(19) Europäisches Patentamt
European Patent Office
Office européen des brevets

(11) **EP 4 700 406 A1**

(12) **EUROPEAN PATENT APPLICATION**
published in accordance with Art. 153(4) EPC

(43) Date of publication:
**25.02.2026  Bulletin 2026/09**

(21) Application number: 25749138.1

(22) Date of filing: **22.01.2025**

(51) International Patent Classification (IPC):
**G01R 31/374** (2019.01)    **G01R 31/396** (2019.01)
**G01R 31/382** (2019.01)    **G01R 31/392** (2019.01)
**G01R 19/12** (2006.01)    **G01R 19/10** (2006.01)
**G01R 19/165** (2006.01)    **B60L 58/10** (2019.01)

(52) Cooperative Patent Classification (CPC):
**B60L 58/10; G01R 19/10; G01R 19/12;**
**G01R 19/165; G01R 31/374; G01R 31/382;**
**G01R 31/392; G01R 31/396;** Y02E 60/10

(86) International application number:
**PCT/KR2025/001239**

(87) International publication number:
**WO 2025/165051 (07.08.2025 Gazette 2025/32)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority:  **30.01.2024  KR 20240014210**

(71) Applicant: **LG Energy Solution, Ltd.**
**Seoul 07335 (KR)**

(72) Inventors:
• **PAK, Seon-Ho**
  **Daejeon 34122 (KR)**
• **JEONG, Hee-Seok**
  **Daejeon 34122 (KR)**
• **CHA, A-Ming**
  **Daejeon 34122 (KR)**
• **BAE, Yoon-Jung**
  **Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **APPARATUS AND METHOD FOR DIAGNOSING BATTERY**

(57)    Disclosed is an apparatus for diagnosing a battery, which includes a profile obtaining unit configured to obtain a charging profile representing a correspondence relationship between a voltage and a current of a battery measured in a charging process; and a control unit configured to calculate a first CC capacity and a first CV capacity from the charging profile, calculate a capacity change rate for the first CC capacity and the first CV capacity based on a second CC capacity and a second CV capacity stored in advance, diagnose a state of the battery based on the calculated capacity change rate and a preset correction coefficient, and set a usage condition for the battery according to the diagnosis result.

FIG. 1

```
                                              ┌─ 100
┌──────────────────────────────────────────┐
│  APPARATUS FOR DIAGNOSING BATTERY          │
│  ┌────────────────────────────────────┐    │
│  │   PROFILE OBTAINING UNIT           │──── 110
│  └────────────────────────────────────┘    │
│  ┌────────────────────────────────────┐    │
│  │       CONTROL UNIT                 │──── 120
│  └────────────────────────────────────┘    │
│  ┌────────────────────────────────────┐    │
│  │       STORAGE UNIT                 │──── 130
│  └────────────────────────────────────┘    │
└──────────────────────────────────────────┘
```

EP 4 700 406 A1

## Description

TECHNICAL FIELD

This application is based on and claims priority from Korean Patent Application No. 10-2024-0014210, filed on January 30, 2024, with the Korean Intellectual Property Office, the disclosure of which is incorporated herein in its entirety by reference.

The present disclosure relates to an apparatus and method for diagnosing a battery, and more particularly, to an apparatus and method for diagnosing a battery, which diagnoses a state of the battery.

BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

A lot of research is being conducted on these batteries in terms of high-capacity and high-density, but the aspect of improving lifespan and safety is also important. In order to improve the safety of the battery, technology to accurately diagnose the current state of the battery is required.

DISCLOSURE

Technical Problem

The present disclosure is designed to solve the problems of the related art, and therefore the present disclosure is directed to providing an apparatus and method for diagnosing a battery, which diagnoses a state of the battery based on a charge capacity of the battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

In one aspect of the present disclosure, there is provided an apparatus for diagnosing a battery, comprising: a profile obtaining unit configured to obtain a charging profile representing a correspondence relationship between a voltage and a current of a battery measured in a charging process; and a control unit configured to calculate a first CC capacity and a first CV capacity from the charging profile, calculate a capacity change rate for the first CC capacity and the first CV capacity based on a second CC capacity and a second CV capacity stored in advance, diagnose a state of the battery based on the calculated capacity change rate and a preset correction coefficient, and set a usage condition for the battery according to the diagnosis result.

The control unit may be configured to calculate a CC capacity difference between the first CC capacity and the second CC capacity, calculate a CV capacity difference between the first CV capacity and the second CV capacity, and calculate the capacity change rate by calculating a ratio of the CC capacity difference and the CV capacity difference.

The control unit may be configured to calculate a decrease amount of the first CC capacity with respect to the second CC capacity as the CC capacity difference and calculate an increase amount of the first CV capacity with respect to the second CV capacity as the CV capacity difference.

The control unit may be configured to calculate a correction change rate by multiplying the capacity change rate by the correction coefficient, compare the correction change rate with a preset threshold value, and diagnose the state of the battery based on the comparison result.

The control unit may be configured to diagnose the state of the battery as a normal state when the correction change rate is greater than or equal to the threshold value.

The control unit may be configured to diagnose the state of the battery as an abnormal state when the correction change rate is less than the threshold value.

The control unit may be configured to output a notification signal to warn of a sudden drop when the state of the battery is diagnosed as the abnormal state.

The control unit may be configured to change a charging current preset for the battery when the correction change rate is less than the threshold value.

The control unit may be configured to change an upper limit of the charging current to a value obtained by multiplying the correction change rate by an upper limit of the charging current.

The correction coefficient may be preset based on a change amount of the CC capacity and a change amount of the CV capacity of the battery during a preset reference number of cycles.

The correction coefficient may be is preset as a ratio of a representative change amount of the CV capacity and a representative change amount of the CC capacity during the preset reference number of cycles.

In another aspect of the present disclosure, there is provided a battery pack comprising the apparatus for diagnosing a battery according to an embodiment of the present disclosure.

In still another aspect of the present disclosure, there is provided a vehicle comprising the apparatus for diagnosing a battery according to an embodiment of the present disclosure.

In still another aspect of the present disclosure, there is provided a method for diagnosing a battery, comprising: a profile obtaining step of obtaining a charging profile representing a correspondence relationship between a voltage and a current of a battery measured in a charging process; a capacity calculating step of calculating a first CC capacity and a first CV capacity from the charging profile; a capacity change rate calculating step of calculating a capacity change rate for the first CC capacity and the first CV capacity based on a second CC capacity and a second CV capacity stored in advance; a diagnosing step of diagnosing a state of the battery based on the calculated capacity change rate and a preset correction coefficient; and a usage condition setting step of setting a usage condition for the battery according to the diagnosis result.

Advantageous Effects

According to one aspect of the present disclosure, the apparatus for diagnosing a battery has the advantage of non-destructively diagnosing the state of a battery in an uncomplicated manner because the apparatus diagnoses the state of a battery from the CC capacity and the CV capacity using a correction coefficient.

In addition, according to one aspect of the present disclosure, the apparatus for diagnosing a battery has the advantage of detecting a battery with a high possibility of sudden drop early.

The effects of the present disclosure are not limited to the effects mentioned above, and other effects not mentioned will be clearly understood by those skilled in the art from the description of the claims.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a diagram schematically showing an apparatus for diagnosing a battery according to an embodiment of the present disclosure.
FIG. 2 is a diagram schematically showing a charging profile according to an embodiment of the present disclosure.
FIGS. 3 to 5 are drawings schematically showing diagnosis results for first to third batteries.
FIG. 6 is a diagram schematically showing a battery pack according to another embodiment of the present disclosure.
FIG. 7 is a diagram schematically showing a vehicle according to still another embodiment of the present disclosure.
FIG. 8 is a diagram for schematically illustrating a method for diagnosing a battery according to still another embodiment of the present disclosure.

BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

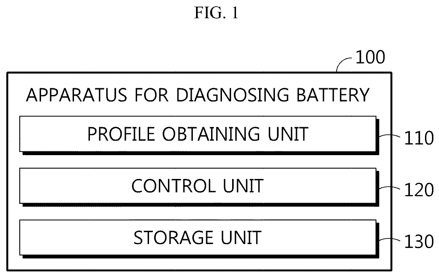

FIG. 1 is a diagram schematically showing an apparatus 100 for diagnosing a battery according to an embodiment of the present disclosure.

Referring to FIG. 1, the apparatus 100 for diagnosing a battery may include a profile obtaining unit 110 and a control unit 120.

Here, the battery refers to an independent cell that has a negative terminal and a positive terminal and is physically separable. As an example, a lithium-ion battery or a lithium polymer battery may be considered as a battery. Additionally, the type of battery may be a cylindrical type, a prismatic type, or a pouch type. Additionally, the battery may mean a battery bank, a battery module or a battery pack in which a plurality of cells are connected in series and/or parallel. Below, for convenience of explanation, the battery is explained as meaning one independent cell.

The profile obtaining unit 110 may be configured to obtain a charging profile CP representing a correspondence relationship between a voltage and a current of a battery measured in a charging process.

For example, the charging profile CP is a profile that represents the correspondence relationship between the voltage (V) and the current (C) when the battery is charged from a preset charge start SOC or 0% to a preset charge end SOC or 100%. That is, the charging profile CP represents the correspondence relationship between the charging voltage and the charging current of the battery.

For example, there is no special limitation on the charging C-rate for generating the charging profile CP. However, preferably, the battery should be charged at a low rate to obtain a more accurate charging profile CP. For example, the charging profile CP may be generated in the process of charging the battery at 0.05C.

For example, the profile obtaining unit 110 may directly receive the charging profile CP from the outside. That is, the profile obtaining unit 110 may obtain the charging profile CP by receiving the charging profile CP by being connected to the outside by wire and/or wirelessly.

As another example, the profile obtaining unit 110 may receive battery information about the voltage and current of the battery. Also, the profile obtaining unit 110 may generate a charging profile CP based on the received battery information. That is, the profile obtaining unit 110 may obtain the charging profile CP by directly generating the charging profile CP based on battery information.

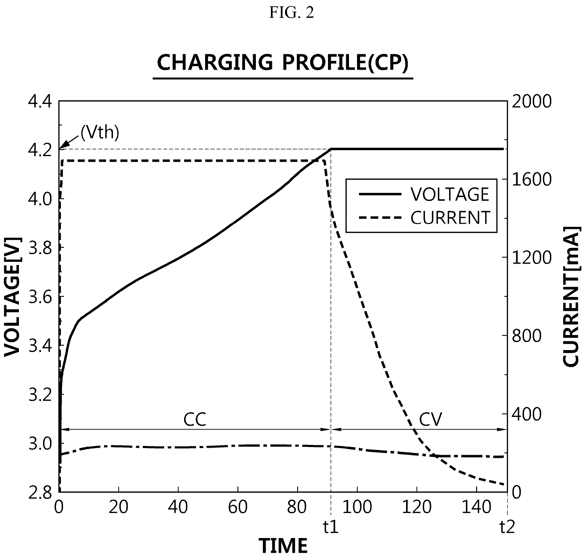

FIG. 2 is a diagram schematically showing a charging profile CP according to an embodiment of the present disclosure.

For example, in the embodiment of FIG. 2, the battery may be charged until the voltage reaches from 3.0 [V] to 4.2 [V]. Specifically, the battery may be charged with a constant current (CC) until the time point t1 when the voltage reaches a preset threshold voltage (Vth), and may be charged with a constant voltage (CV) from after the time point t1 to the end time point t2. Here, the threshold voltage (Vth) is also called a cut-off voltage.

The profile obtaining unit 110 may be connected to communicate with the control unit 120. For example, the profile obtaining unit 110 may be connected to the control unit 120 by wire and/or wirelessly. The profile obtaining unit may transmit the obtained charging profile CP to the control unit 120.

The control unit 120 may be configured to calculate a first CC capacity and a first CV capacity from the charging profile CP.

Specifically, the control unit 120 may calculate the first CC capacity and the first CV capacity of the battery from the charging profile CP by using the current counting method (ampere counting method or coulomb counting method). Here, the first CC capacity is a charge capacity while the battery is being CC-charged, and the first CV capacity is a charge capacity while the battery while is being CV-charged.

For example, in the embodiment of FIG. 2, the control unit 120 may calculate the first CC capacity by integrating the current amount at the time point 0 to t1. Also, the control unit 120 may calculate the first CV capacity by integrating the current amount at the time point t1 to t2.

The control unit 120 may be configured to calculate a capacity change rate for the first CC capacity and the first CV capacity based on a second CC capacity and a second CV capacity stored in advance.

Specifically, the second CC capacity is a CC capacity of the battery that is stored in advance, and means a CC capacity of the battery calculated at a previous time point. Similarly, the second CV capacity is a CV capacity of the battery that is stored in advance, and means a CV capacity of the battery that is calculated at a previous time point. For example, it is assumed that the present is the $n^{th}$ (where n is a natural number greater than or equal to 2) cycle. The control unit 120 may calculate the first CC capacity and the first CV capacity in the $n^{th}$ cycle. Also, the CC capacity calculated in the $n-1^{th}$ cycle may be the second CC capacity that is stored in advance, and the calculated CV capacity may be the second CV capacity that is stored in advance. In this embodiment, it is described that the cycle ($n-1^{th}$ cycle) in which the second CC capacity and the second CV capacity are calculated and the cycle ($n^{th}$ cycle) in which the first CC capacity and the first CV capacity are calculated are apart from each other by 1 cycle, but it should be noted that the cycle gap may change depending on the diagnosis cycle of the battery, the diagnosis condition, the diagnosis method, or the like.

Specifically, the control unit 120 may be configured to calculate a CC capacity difference between the first CC capacity and the second CC capacity.

Preferably, the CC capacity may decrease as the battery degrades. Since the second CC capacity is calculated before the first CC capacity, the second CC capacity may be greater than or equal to the first CC capacity. Therefore, the control unit 120 may be configured to calculate the decrease amount of the first CC capacity with respect to the second CC capacity as the CC capacity difference. For example, the control unit 120 may calculate the CC capacity difference by calculating the formula "second CC capacity - first CC capacity".

In addition, the control unit 120 may be configured to calculate a CV capacity difference between the first CV capacity and the second CV capacity.

Preferably, the CV capacity may increase as the battery degrades. Since the second CV capacity is calculated before the first CV capacity, the second CV capacity may be less than or equal to the first CV capacity. Therefore, the control unit 120 may be configured to calculate the increase amount of the first CV capacity with respect to the second CV capacity as the CV capacity difference. For example, the control unit 120 may calculate the CV capacity difference by calculating the formula "first CV capacity - second CV capacity".

Finally, the control unit 120 may be configured to calculate a capacity change rate by calculating the ratio of the CC capacity difference and the CV capacity difference.

For example, the control unit 120 may calculate the capacity change rate by calculating the ratio of the CV capacity difference to the CC capacity difference. That is, the control unit 120 may calculate the capacity change rate by calculating the formula "CV capacity difference ÷ CC capacity difference".

As another example, the control unit 120 may calculate the capacity change rate by calculating the ratio of the CC capacity difference to the CV capacity difference. That is, the control unit 120 may calculate the capacity change rate by calculating the formula "CC capacity difference ÷ CV capacity difference".

Hereinafter, for convenience of explanation, it is assumed that the capacity change rate is the ratio of the CV capacity difference to the CC capacity difference.

The control unit 120 may be configured to diagnose the state of the battery based on the calculated capacity change rate and a preset correction coefficient.

Specifically, the control unit 120 may be configured to calculate the correction change rate by multiplying the capacity change rate by the correction coefficient. That is, the correction change rate is a value obtained by multiplying the capacity change rate by the correction coefficient.

For example, the control unit 120 may calculate the correction change rate using Formula 1 below.

[Formula 1]

$$CC_n = \frac{QV_n - QV_{n-1}}{QC_{n-1} - QC_n} \times \alpha$$

Here, n is a natural number greater than or equal to 2, and is a factor representing the cycle time point. $CC_n$ is a correction change rate of the $n^{th}$ cycle, $QV_n$ is the first CV capacity of the $n^{th}$ cycle, and $QV_{n-1}$ is the second CV capacity of the $n^{th}$ cycle. $QC_n$ is the first CC capacity of the $n^{th}$ cycle, $QC_{n-1}$ is the second CC capacity of the $n-1^{th}$ cycle, and $\alpha$ is a correction coefficient. Also, the capacity change rate is "$(QV_n-QV_{n-1}) \div (QC_{n-1}-QC_n)$".

In addition, the correction coefficient may be preset based on the change amount of the CC capacity and the change amount of the CV capacity of the battery during a preset reference number of cycles.

Specifically, the correction coefficient may be preset as a ratio of a representative change amount of the CV capacity and a representative change amount of the CC capacity during a reference number of cycles.

Preferably, the correction coefficient may be set for the battery in a BOL (Beginning Of Life) state. That is, the correction coefficient may be set based on the representative change amount of the CV capacity and the representative change amount of the CC capacity during a reference number of cycles from the first cycle of the battery. Here, the representative change amount may be a minimum change amount, a maximum change amount, an average change amount, or an intermediate change amount.

For example, it is assumed that the preset reference number is 10 and the representative change amount is the average change amount. The change amount of the CV capacity and the change amount of the CC capacity from the first cycle to the $10^{th}$ cycle of the battery may be calculated. Here, since the change amount of the CV capacity and the change amount of the CV capacity are calculated for each cycle from the second cycle, a total of 9 change amounts of the CV capacity and change amounts of the CC capacity may be calculated. The average value of the 9 change amounts of the CV capacity may be set as the representative change amount of the CV capacity, and the average value of the 9 change amounts of the CC capacity may be set as the representative change amount of the CC capacity. In addition, the correction coefficient may be set according to the ratio of the average value of the change amounts of the CV capacity and the average value of the change amounts of the CC capacity.

For example, the correction coefficient may be preset according to Formula 2 below.

[Formula 2]

$$\alpha = \frac{dQC_{ref}}{dQV_{ref}}$$

Here, $\alpha$ is the correction coefficient, $dQC_{ref}$ is the representative change amount of the CC capacity, and $dQV_{ref}$ is the representative change amount of the CV capacity.

The control unit 120 may be configured to compare the correction change rate with a preset threshold value (th) and diagnose the state of the battery based on the comparison result.

Specifically, the control unit 120 may compare the magnitude of the correction change rate and the threshold value (th). Here, the threshold value (th) is a measure that distinguishes the state of the battery into a normal state or an abnormal state according to the correction change rate.

For example, the control unit 120 may diagnose the state of the battery as a normal state if the correction change rate is greater than or equal to the threshold value (th). As another example, the control unit 120 may be configured to diagnose the state of the battery as an abnormal state if the correction change rate is less than the threshold value (th).

In theory, if the CC capacity decreases as the battery degrades, the CV capacity should increase by the decrease amount. However, if the battery actually degrades, the CV capacity does not increase by the decrease amount in the CC capacity. Therefore, the control unit 120 corrects the capacity change rate calculated for the $n^{th}$ cycle and the $n-1^{th}$ cycle with the correction coefficient, and determines whether the battery degradation is normal or abnormal based on the correction change rate.

For example, it is assumed that the average change amount (average decrease amount) of the CC capacity is 1, the average change amount (average increase amount) of the CV capacity is 0.5, and the threshold value (th) is set to 1. In this case, according to Formula 2, the correction coefficient may be preset to 2. The control unit 120 may diagnose the state of the battery as a normal state if the correction change rate calculated by multiplying the capacity change rate and the correction coefficient is 1 or greater. Conversely, the control unit 120 may diagnose the state of the battery as an abnormal state if the correction change rate is less than 1.

That is, if the correction change rate multiplied by the correction coefficient is less than the threshold value (th), the balance between the decrease amount of the CC capacity and the increase amount of the CV capacity is significantly broken. Therefore, in this case, the control unit 120 may diagnose the state of the battery as an abnormal state.

The apparatus 100 for diagnosing a battery has the advantage of non-destructively diagnosing the state of the battery through an uncomplicated method because the apparatus diagnoses the state of the battery from the CC capacity and CV capacity using the correction coefficient.

Meanwhile, the profile obtaining unit 110 and the control unit 120 included in the apparatus 100 for diagnosing a battery optionally include a processor, an application-specific integrated circuit (ASIC), other chipset, a logic circuit, a register, a communication modem, a data processing device, etc. known in the art to execute various control logics performed in the present disclosure. Also, when the control logic is implemented as software, the profile obtaining unit 110 and the control unit 120 may be implemented as a set of program modules. At this time, the program module may be stored in the memory and executed by the profile obtaining unit 110 and the control unit 120. The memory may be inside or outside the profile obtaining unit 110 and the control unit 120 and may be connected to the profile obtaining unit 110 and the control unit 120 by various well-known means.

In addition, the apparatus 100 for diagnosing a battery may further include a storage unit 130. The storage unit 130 may store data necessary for operation and function of each component of the apparatus 100 for diagnosing a battery, data generated in the process of performing the operation or function, or the like. The storage unit 130 is not particularly limited in its kind as long as it is a known information storage means that can record, erase, update and read data. As an example, the information storage means may include RAM (Random access memory), flash memory, ROM (Read-only memory), EEPROM (Electrically erasable programmable read-only memory), registers, and the like. In addition, the storage unit 130 may store program codes in which processes executable by the profile obtaining unit 110 and the control unit 120 are defined.

The control unit 120 may be configured to output a notification signal to warn of a sudden drop if the state of the battery is diagnosed as an abnormal state.

Specifically, in a battery diagnosed as in an abnormal state, the decrease rate in CC capacity is greater than the increase rate in CV capacity. In other words, the battery diagnosed as in an abnormal state may be in a state where the lifespan is rapidly deteriorating. Therefore, a battery diagnosed as in an abnormal state has a very high possibility of experiencing a sudden drop at an unexpected moment.

If the battery is installed and used in a device such as a bicycle, a motorcycle, a vehicle, a drone, or an ESS, the device may turn off if a sudden drop occurs in the battery. For example, if a sudden drop occurs in the battery, the vehicle or other transportation device turns off, which may result in casualties, and if the device such as a drone turns off, financial damage such as damage and/or loss of the device may occur. In addition, damage to the device may also result in casualties.

Therefore, the apparatus 100 for diagnosing a battery has the advantage of preventing unexpected accidents caused by a sudden drop in the battery by determining the possibility of sudden drop in the battery based on the CC capacity and the CV capacity that may be easily obtained from the charging profile CP. In addition, the apparatus 100 for diagnosing a battery may provide a warning for a battery with a high possibility of sudden drop by externally outputting a notification signal regarding the diagnosis result.

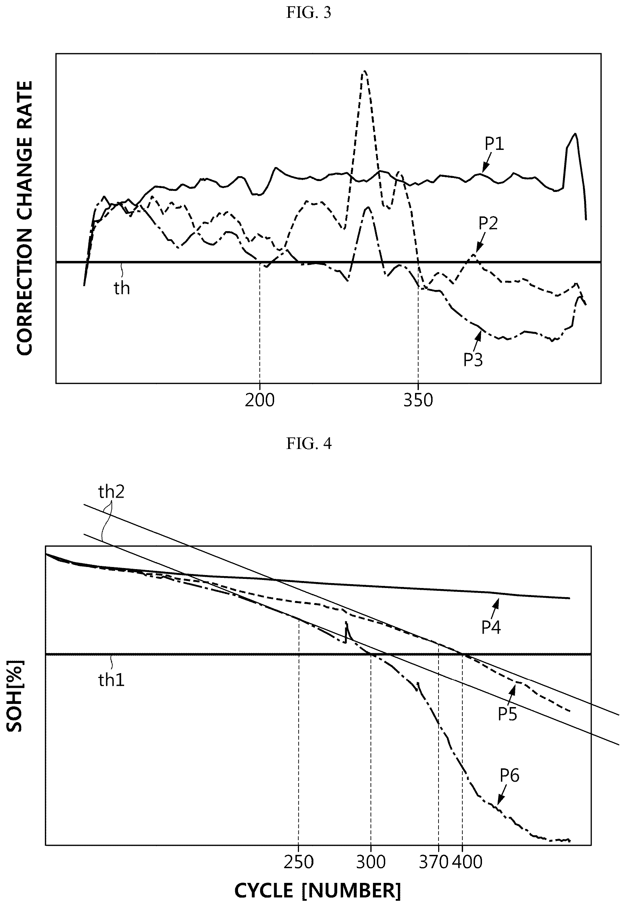

FIGS. 3 to 5 are drawings schematically showing diagnosis results for first to third batteries.

Specifically, the first battery is a battery designed to degrade slowly as the cycles progress, the second battery is a battery designed to degrade at a normal level as the cycles progress, and the third battery is a battery designed to degrade rapidly as the cycles progress.

In the embodiment of FIG. 3, the first profile P1 is a profile representing the correction change rate of each cycle for the first battery, the second profile P2 is a profile representing the correction change rate of each cycle for the second battery, and the third profile P3 is a profile representing the correction change rate of each cycle for the third battery.

The control unit 120 may diagnose the state of the battery by comparing the correction change rate of the first to third batteries for each cycle with the preset threshold value (th). The first battery may be diagnosed as a normal state throughout the cycles, the second battery may be diagnosed as an abnormal state for the first time at the 350th cycle, and the third battery may be diagnosed as an abnormal state for the first time at the 200th cycle.

In the embodiment of FIG. 4, the fourth profile P4 is a profile showing the SOH (State Of Health) of each cycle for the first battery, the fifth profile P5 is a profile showing the SOH of each cycle for the second battery, and the sixth profile P6 is a profile showing the SOH of each cycle for the third battery.

The control unit 120 may diagnose the state of the battery by comparing the SOH of the first to third batteries for each cycle with the preset first threshold value (th1). Here, the first threshold value (th1) may be preset as a reference SOH that may distinguish the state of the battery into a normal state or an abnormal state. The first battery may be diagnosed as a normal state throughout the cycles, the second battery may be diagnosed as an abnormal state for the first time at the 400th cycle, and the third battery may be diagnosed as an abnormal state for the first time at the 300th cycle.

In addition, the control unit 120 may diagnose the state of the battery by comparing the SOH change rate of the first to third batteries for each cycle with a preset second threshold value (th2). Here, the second threshold value (th2) may be preset as a reference SOH change rate that may distinguish the state of the battery into a normal state or an abnormal state. The first battery may be diagnosed as a normal state throughout the cycles, the second battery may be diagnosed as an abnormal state for the first time at the 370th cycle, and the third battery may be diagnosed as an abnormal state for the first time at the 250th cycle.

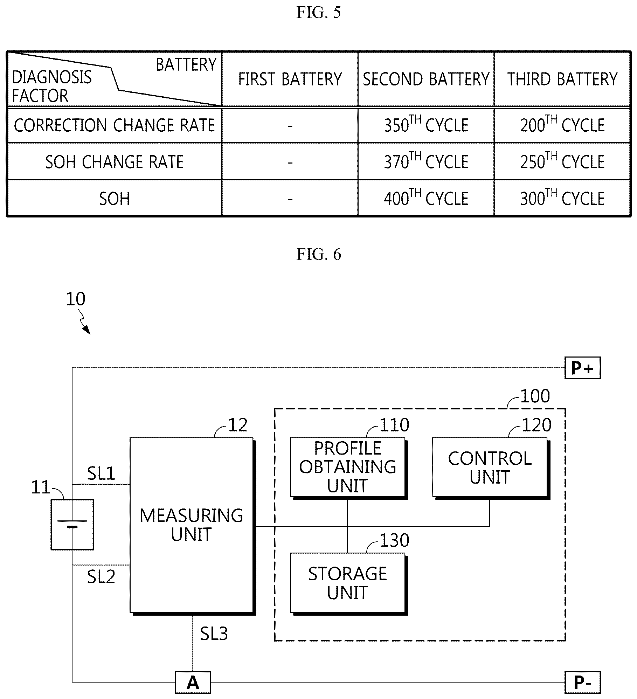

Referring to FIG. 5, when diagnosing the state of the battery based on the correction change rate among the correction change rate, the SOH, and the SOH change rate, it may be confirmed that the cycle that is first diagnosed as an abnormal state is the earliest. Therefore, according to an embodiment of the present disclosure, there is an advantage of detecting a battery with a high possibility of sudden drop early.

The control unit 120 may be configured to set a usage condition for the battery based on the diagnosis result. Here, the usage condition is a condition used for operating the battery, and may include a charging current, an allowable temperature, an available voltage, an available SOC, and the like.

Specifically, the control unit 120 may be configured to change a charging current preset for the battery if the correction change rate is less than a threshold value. Since the correction change rate is a value related to a decrease amount of the CC capacity and an increase amount of the CV capacity when the battery is charged, a usage condition related to charging should be controlled in order to reduce the possibility of a sudden drop of the battery. In particular, among the usage conditions related to charging, changing a usage condition directly related to the CC capacity and the CV capacity is an appropriate measure for the battery. Therefore, the control unit 120 may change the charging current preset for the battery if the state of the battery is diagnosed as an abnormal state.

Preferably, the control unit 120 may reduce the charging current preset for the battery. If the charging current is reduced, the overvoltage is reduced, so that the time for the voltage of the battery to reach the threshold voltage (Vth) may be increased. That is, if the charging current is reduced, the CC capacity may be increased more than before due to the reduction in the overvoltage.

In order to reduce the preset charging current, the control unit 120 may change the upper limit of the charging current based on the correction change rate. For example, the control unit 120 may be configured to change the upper limit of the charging current to a value obtained by multiplying the correction change rate and the upper limit of the charging current. That is, since the correction change rate is a value less than the threshold value (e.g., 1), a value obtained by multiplying the upper limit of the preset charging current by the correction change rate may be smaller than the upper limit of the preset charging current.

In addition, the correction change rate is a factor that reflects the capacity change behavior of the battery. Therefore, the control unit 120 may change the upper limit of the charging current set for the battery to correspond to the capacity change behavior of the battery by reducing the upper limit of the preset charging current using the correction change rate.

That is, the apparatus 100 for diagnosing a battery may rapidly diagnose the state of the battery based on the correction change rate, and significantly reduce the possibility of occurrence of a sudden drop in the battery by changing the upper limit of the charging current for the battery from the diagnosis time point. Therefore, the apparatus 100 for diagnosing a battery may increase the expected life of the battery.

The apparatus 100 for diagnosing a battery according to the present disclosure can be applied to the BMS. In other words, the BMS according to the present disclosure may include the above-described apparatus 100 for diagnosing a battery. In this configuration, at least some of the components of the apparatus 100 for diagnosing a battery may be implemented by supplementing or adding functions of components included in a conventional BMS. For example, the profile obtaining unit 110, the control unit 120 and the storage unit 130 of the apparatus 100 for diagnosing a battery may be implemented as components of a BMS.

Additionally, the apparatus 100 for diagnosing a battery according to the present disclosure may be provided in the battery pack. That is, the battery pack according to the present disclosure may include the above-described apparatus 100 for diagnosing a battery and at least one battery cell. Additionally, the battery pack may further include electrical components (relays, fuses, etc.) and a case.

FIG. 6 is a diagram schematically showing a battery pack 10 including according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to a first sensing line SL1, a second sensing line SL2, and a third sensing line SL3. Specifically, the measuring unit 12 may be connected to the positive electrode terminal of the battery 11 through the first sensing line SL1, and connected to the negative electrode terminal of the battery 11 through the second sensing line SL2. The measuring unit 12 may measure the voltage of the battery 11 based on the voltage measured at each of the first sensing line SL1 and the second sensing line SL2.

In addition, the measuring unit 12 can be connected to a current measurement unit A through the third sensing line SL3. For example, the current measurement unit A may be an ammeter or shunt resistor that can measure the charging current and discharging current of the battery 11. The measuring unit 12 may calculate the charging amount by measuring the charging current of the battery 11 through the third sensing line SL3. Additionally, the measuring unit 12 can calculate the discharge amount by measuring the discharge current of the battery 11 through the third sensing line SL3.

For example, the profile obtaining unit 110 may receive battery information about the voltage and current of the battery from the measuring unit 12. Then, the profile obtaining unit 110 may generate a charging profile CP based on the battery information.

As another example, the profile obtaining unit 110 may receive a charging profile CP from the measuring unit 12.

An external device may be connected to the positive electrode terminal P+ and the negative electrode terminal P- of the battery pack 10. For example, the external device may be a charging device or a load. In addition, the positive electrode terminal of the battery 11, the positive electrode terminal P+ of the battery pack 10, the external device, the negative electrode terminal P- of the battery pack 10, and the negative electrode terminal of the battery 11 may be electrically connected.

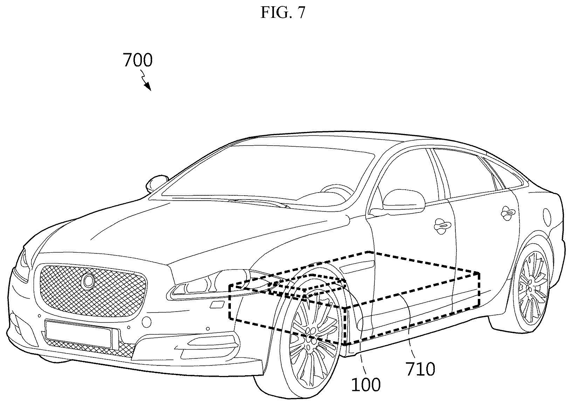

FIG. 7 is a diagram schematically showing a vehicle 700 according to still another embodiment of the present disclosure.

Referring to FIG. 7, the battery pack 710 according to an embodiment of the present disclosure may be included in a vehicle 700 such as an electric vehicle (EV) or a hybrid vehicle (HV). In addition, the battery pack 710 may drive the vehicle 700 by supplying power to a motor through an inverter included in the vehicle 700. Here, the battery pack 710 may include the apparatus 100 for diagnosing a battery. That is, the vehicle 700 may include the apparatus 100 for diagnosing a battery. In this case, the apparatus 100 for diagnosing a battery may be an on-board device included in the vehicle 700.

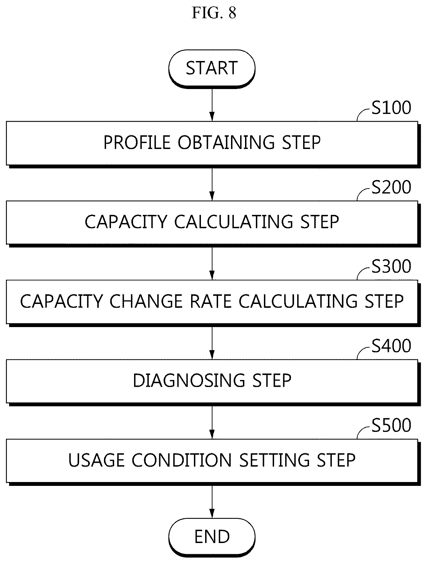

FIG. 8 is a diagram for schematically illustrating a method for diagnosing a battery according to still another embodiment of the present disclosure.

Referring to FIG. 8, the method for diagnosing a battery may include a profile obtaining step (S100), a capacity calculating step (S200), a capacity change rate calculating step (S300), a diagnosing step (S400), and a usage condition setting step (S500).

Preferably, each step of the method for diagnosing a battery can be performed by the apparatus 100 for diagnosing a battery. Hereinafter, for convenience of explanation, content that overlaps with the content described above will be omitted or briefly described.

The profile obtaining step (S100) is a step of obtaining a charging profile CP representing a correspondence relationship between voltage and current of a battery measured in a charging process, and may be performed by the profile obtaining unit 110.

For example, the profile obtaining unit 110 may directly receive the charging profile CP from the outside. That is, the profile obtaining unit 110 may obtain the charging profile CP by receiving the charging profile CP by being connected to the outside wired and/or wirelessly.

As another example, the profile obtaining unit 110 may receive battery information about the voltage and current of the battery. Additionally, the profile obtaining unit 110 may generate a charging profile CP based on the received battery information. That is, the profile obtaining unit 110 may obtain the charging profile CP by directly generating the charging profile CP based on the battery information.

The capacity calculating step (S200) is a step of calculating a first CC capacity and a first CV capacity from the charging profile CP, and may be performed by the control unit 120.

For example, the control unit 120 may calculate the first CC capacity and the first CV capacity of the battery from the charging profile CP using the current counting method (ampere counting method or coulomb counting method).

The capacity change rate calculating step (S300) is a step of calculating a capacity change rate for the first CC capacity and the first CV capacity based on a second CC capacity and a second CV capacity stored in advance, and may be performed by the control unit 120.

For example, the control unit 120 may calculate a CC capacity difference between the first CC capacity and the second CC capacity, calculate a CV capacity difference between the first CV capacity and the second CV capacity, and calculate a capacity change rate by calculating the ratio of the CC capacity difference and the CV capacity difference.

The diagnosing step (S400) is a step for diagnosing a state of the battery based on the calculated capacity change rate and a preset correction coefficient, and may be performed by the control unit 120.

For example, the control unit 120 may calculate the correction change rate by multiplying the capacity change rate by the correction coefficient. Also, the control unit 120 may diagnose the state of the battery as a normal state if the correction change rate is greater than or equal to a threshold value (th). Conversely, the control unit 120 may diagnose the state of the battery as an abnormal state if the correction change rate is less than the threshold value (th).

The usage condition setting step (S500) is a step of setting a usage condition for the battery according to the diagnosis result, and may be performed by the control unit 120.

For example, the control unit 120 may be configured to change the upper limit of the charging current to a value obtained by multiplying the correction change rate and the upper limit of the charging current.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

(Reference Signs)

10: battery pack
11: battery
12: measuring unit
100: apparatus for diagnosing a battery
110: profile obtaining unit
120: control unit
130: storage unit
400: vehicle
410: battery pack

**Claims**

1. An apparatus for diagnosing a battery, comprising:

   a profile obtaining unit configured to obtain a charging profile representing a correspondence relationship between a voltage and a current of a battery measured in a charging process; and
   a control unit configured to calculate a first CC capacity and a first CV capacity from the charging profile, calculate a capacity change rate for the first CC capacity and the first CV capacity based on a second CC capacity and a second CV capacity stored in advance, diagnose a state of the battery based on the calculated capacity change rate and a preset correction coefficient, and set a usage condition for the battery according to the diagnosis result.

2. The apparatus for diagnosing a battery according to claim 1,
   wherein the control unit is configured to calculate a CC capacity difference between the first CC capacity and the second CC capacity, calculate a CV capacity difference between the first CV capacity and the second CV capacity, and calculate the capacity change rate by calculating a ratio of the CC capacity difference and the CV capacity difference.

3. The apparatus for diagnosing a battery according to claim 2,
   wherein the control unit is configured to calculate a decrease amount of the first CC capacity with respect to the second CC capacity as the CC capacity difference and calculate an increase amount of the first CV capacity with respect to the second CV capacity as the CV capacity difference.

4. The apparatus for diagnosing a battery according to claim 1,
   wherein the control unit is configured to calculate a correction change rate by multiplying the capacity change rate by the correction coefficient, compare the correction change rate with a preset threshold value, and diagnose the state of the battery based on the comparison result.

**5.** The apparatus for diagnosing a battery according to claim 4,

wherein the control unit is configured to diagnose the state of the battery as a normal state when the correction change rate is greater than or equal to the threshold value, and
wherein the control unit is configured to diagnose the state of the battery as an abnormal state when the correction change rate is less than the threshold value.

**6.** The apparatus for diagnosing a battery according to claim 5,
wherein the control unit is configured to output a notification signal to warn of a sudden drop when the state of the battery is diagnosed as the abnormal state.

**7.** The apparatus for diagnosing a battery according to claim 4,
wherein the control unit is configured to change a charging current preset for the battery when the correction change rate is less than the threshold value.

**8.** The apparatus for diagnosing a battery according to claim 7,
wherein the control unit is configured to change an upper limit of the charging current to a value obtained by multiplying the correction change rate by an upper limit of the charging current.

**9.** The apparatus for diagnosing a battery according to claim 1,
wherein the correction coefficient is preset based on a change amount of the CC capacity and a change amount of the CV capacity of the battery during a preset reference number of cycles.

**10.** The apparatus for diagnosing a battery according to claim 9,
wherein the correction coefficient is preset as a ratio of a representative change amount of the CV capacity and a representative change amount of the CC capacity during the preset reference number of cycles.

**11.** A battery pack comprising the apparatus for diagnosing a battery according to any one of claims 1 to 10.

**12.** A vehicle comprising the apparatus for diagnosing a battery according to any one of claims 1 to 10.

**13.** A method for diagnosing a battery, comprising:

a profile obtaining step of obtaining a charging profile representing a correspondence relationship between a voltage and a current of a battery measured in a charging process;
a capacity calculating step of calculating a first CC capacity and a first CV capacity from the charging profile;
a capacity change rate calculating step of calculating a capacity change rate for the first CC capacity and the first CV capacity based on a second CC capacity and a second CV capacity stored in advance;
a diagnosing step of diagnosing a state of the battery based on the calculated capacity change rate and a preset correction coefficient; and
a usage condition setting step of setting a usage condition for the battery according to the diagnosis result.

FIG. 1

APPARATUS FOR DIAGNOSING BATTERY — 100

| | |
|---|---|
| PROFILE OBTAINING UNIT | 110 |
| CONTROL UNIT | 120 |
| STORAGE UNIT | 130 |

FIG. 2

## CHARGING PROFILE(CP)

FIG. 3

FIG. 4

FIG. 5

| DIAGNOSIS FACTOR | BATTERY | FIRST BATTERY | SECOND BATTERY | THIRD BATTERY |
|---|---|---|---|---|
| CORRECTION CHANGE RATE | | - | 350$^{TH}$ CYCLE | 200$^{TH}$ CYCLE |
| SOH CHANGE RATE | | - | 370$^{TH}$ CYCLE | 250$^{TH}$ CYCLE |
| SOH | | - | 400$^{TH}$ CYCLE | 300$^{TH}$ CYCLE |

FIG. 6

10

P+

100

110
PROFILE OBTAINING UNIT

120
CONTROL UNIT

12
MEASURING UNIT

SL1

11

SL2

130
STORAGE UNIT

SL3

A

P-

FIG. 7

FIG. 8

```
        ┌─────────────┐
        │    START    │
        └──────┬──────┘
               │              ┌S100
               ▼
   ┌──────────────────────────────────┐
   │      PROFILE OBTAINING STEP       │
   └──────────────┬───────────────────┘
                  │           ┌S200
                  ▼
   ┌──────────────────────────────────┐
   │     CAPACITY CALCULATING STEP     │
   └──────────────┬───────────────────┘
                  │           ┌S300
                  ▼
   ┌──────────────────────────────────┐
   │ CAPACITY CHANGE RATE CALCULATING  │
   │              STEP                 │
   └──────────────┬───────────────────┘
                  │           ┌S400
                  ▼
   ┌──────────────────────────────────┐
   │         DIAGNOSING STEP           │
   └──────────────┬───────────────────┘
                  │           ┌S500
                  ▼
   ┌──────────────────────────────────┐
   │    USAGE CONDITION SETTING STEP   │
   └──────────────┬───────────────────┘
                  │
                  ▼
        ┌─────────────┐
        │     END     │
        └─────────────┘
```

## INTERNATIONAL SEARCH REPORT

International application No.

**PCT/KR2025/001239**

| A. | CLASSIFICATION OF SUBJECT MATTER |
|---|---|

**G01R 31/374**(2019.01)i; **G01R 31/396**(2019.01)i; **G01R 31/382**(2019.01)i; **G01R 31/392**(2019.01)i; **G01R 19/12**(2006.01)i; **G01R 19/10**(2006.01)i; **G01R 19/165**(2006.01)i; **B60L 58/10**(2019.01)i

According to International Patent Classification (IPC) or to both national classification and IPC

| B. | FIELDS SEARCHED |
|---|---|

Minimum documentation searched (classification system followed by classification symbols)

G01R 31/374(2019.01); G01R 31/36(2006.01); G01R 31/367(2019.01); G01R 31/396(2019.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 진단(diagnosis), CC 용량(constant current capacity), CV 용량(constant voltage capacity), 변화율(change rate), 보정 계수(correction factor)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | US 2023-0015318 A1 (SOUTHWEST RESEARCH INSTITUTE) 19 January 2023 (2023-01-19)<br>See paragraphs [0012]-[0027] and figures 1-4. | 1-13 |
| A | KR 10-2618037 B1 (LG ENERGY SOLUTION, LTD.) 27 December 2023 (2023-12-27)<br>See paragraphs [0040]-[0180] and figures 1-12. | 1-13 |
| A | KR 10-2021-0150217 A (LG ENERGY SOLUTION, LTD.) 10 December 2021 (2021-12-10)<br>See paragraphs [0040]-[0120] and figures 3-7. | 1-13 |
| A | KR 10-2022-0067328 A (LG ENERGY SOLUTION, LTD.) 24 May 2022 (2022-05-24)<br>See paragraphs [0030]-[0131] and figures 1-6. | 1-13 |
| A | KR 10-2020-0140093 A (SAMSUNG SDI CO., LTD. et al.) 15 December 2020 (2020-12-15)<br>See paragraphs [0036]-[0099] and figures 1-5b. | 1-13 |

☐ Further documents are listed in the continuation of Box C.　　☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **12 May 2025** | **12 May 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2025/001239**

| Patent document cited in search report | | | Publication date (day/month/year) | Patent family member(s) | | | Publication date (day/month/year) |
|---|---|---|---|---|---|---|---|
| US | 2023-0015318 | A1 | 19 January 2023 | US | 11901759 | B2 | 13 February 2024 |
| KR | 10-2618037 | B1 | 27 December 2023 | CN | 118475846 | A | 09 August 2024 |
| | | | | EP | 4428553 | A1 | 11 September 2024 |
| | | | | JP | 2024-546692 | A | 26 December 2024 |
| | | | | WO | 2023-249298 | A1 | 28 December 2023 |
| KR | 10-2021-0150217 | A | 10 December 2021 | CN | 114270204 | A | 01 April 2022 |
| | | | | CN | 114270204 | B | 03 May 2024 |
| | | | | EP | 4063883 | A1 | 28 September 2022 |
| | | | | EP | 4063883 | B1 | 09 October 2024 |
| | | | | JP | 2022-544981 | A | 24 October 2022 |
| | | | | JP | 7331326 | B2 | 23 August 2023 |
| | | | | PL | 4063883 | T3 | 03 February 2025 |
| | | | | US | 12044744 | B2 | 23 July 2024 |
| | | | | US | 2023-0333174 | A1 | 19 October 2023 |
| | | | | WO | 2021-246655 | A1 | 09 December 2021 |
| KR | 10-2022-0067328 | A | 24 May 2022 | CN | 115917335 | A | 04 April 2023 |
| | | | | EP | 4155743 | A1 | 29 March 2023 |
| | | | | JP | 2023-515842 | A | 14 April 2023 |
| | | | | JP | 7443648 | B2 | 06 March 2024 |
| | | | | US | 2023-0176128 | A1 | 08 June 2023 |
| | | | | WO | 2022-108344 | A1 | 27 May 2022 |
| KR | 10-2020-0140093 | A | 15 December 2020 | EP | 3748380 | A1 | 09 December 2020 |
| | | | | EP | 3748380 | B1 | 04 May 2022 |
| | | | | HU | E059979 | T2 | 28 January 2023 |
| | | | | KR | 10-2731011 | B1 | 19 November 2024 |
| | | | | PL | 3748380 | T3 | 20 June 2022 |
| | | | | US | 11293987 | B2 | 05 April 2022 |
| | | | | US | 2020-0386819 | A1 | 10 December 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240014210